# DEMANDE DE BREVET EUROPEEN

(11) **EP 1 246 015 A1**
(43) Date de publication de la demande: **02.10.2002**
(21) Numéro de dépôt: 02290564.0
(22) Date de dépôt: 07.03.2002
(51) Int. Cl.: G03F 7/20, G03B 27/20, H05K 3/00

(54) **Châssis d'exposition à la lumière d'un circuit imprimé**

(30) Priorité: 28.03.2001 FR 0104185
(71) Demandeur: Automa-Tech, 27100 Val de Reuil (FR)
(72) Inventeur: Sorel, Alain, 27180 Les Baux St Croix (FR); Cousin, Christophe, 27190 Orvaux (FR)
(74) Mandataire: Dronne, Guy

(57) **Abrégé**

L'invention concerne un châssis d'exposition à la lumière des deux faces d'un panneau (P) en vue de réaliser un circuit imprimé double face à l'aide d'un premier (CA) et d'un deuxième cliché (CP) souple. Il comprend :
- un premier cadre (12), dépourvu de support plan transparent, pour recevoir le premier cliché souple (CA) ;
- un deuxième cadre (16), dépourvu de support plan transparent, pour recevoir le deuxième cliché souple (CP) ;
- des moyens pour positionner et fixer la périphérie desdits clichés respectivement sur lesdits cadres ;
- des moyens (30) pour positionner et maintenir ledit panneau (P) entre lesdits cadres ;
- des moyens pour provoquer le rapprochement desdits cadres vers les faces dudit panneau; et
- des moyens (50) pour réaliser une dépression dans l'espace (V) compris entre les cadres (12, 16) et contenant ledit panneau.

## Description

La présente invention a pour objet un châssis d'exposition d'un panneau de circuit imprimé double face à la lumière.

De façon plus précise, l'invention concerne un système qui permet de disposer avec une grande précision deux clichés de part et d'autre d'un panneau sur lequel on veut réaliser un circuit imprimé et à soumettre les deux faces de cet ensemble à des faisceaux lumineux afin d'insoler les deux faces du panneau de circuit imprimé à travers les clichés.

Il est bien connu, pour la réalisation d'un panneau de circuit imprimé double face, c'est-à-dire pour la réalisation de pistes conductrices sur les deux faces d'un support isolant, que l'on part d'un ensemble constitué d'un support isolant et d'une couche métallique conductrice réalisée sur chacune des faces du support isolant et de revêtir les deux couches conductrices d'un dépôt photosensible. En soumettant la couche photosensible à un faisceau lumineux à travers un cliché donnant en positif ou en négatif la forme des pistes conductrices, on peut transformer localement la couche photosensible et ainsi ultérieurement attaquer par voie chimique les parties de la couche conductrice de la couche photosensible insolée ou au contraire de la partie de la couche photosensible non insolée puis, à travers le masque ainsi réalisé, attaquer chimiquement la couche conductrice pour ne laisser subsister que les pistes conductrices.

Une telle machine d'insolation ou d'exposition à la lumière est constituée par un ensemble mécanique appelé châssis d'exposition et par une source lumineuse apte à réaliser les deux faisceaux qui viendront insoler les deux faces du panneau de circuit imprimé. La présente invention concerne plus spécifiquement le châssis d'exposition, c'est-à-dire la machine mécanique permettant l'insolation.

Le châssis d'exposition permet d'une part de positionner très précisément sur les deux faces du panneau de circuit imprimé les clichés et d'autre part d'appliquer directement les clichés sur les faces du panneau afin d'éviter tout effet de diffusion lors de l'exposition à la lumière.

Dans les demandes de brevets européens EP 618 505, EP 807 855 et EP 807 856 déposées au nom de la demanderesse, on a déjà décrit des châssis d'exposition qui sont constitués par un bâti portant un support inférieur pour le cliché inférieur, un support supérieur pour le cliché supérieur et des moyens de positionnement du panneau entre les deux clichés. Le support supérieur, le plus souvent, est mobile pour venir sensiblement au contact du panneau disposé entre les deux cadres. Puis, en réalisant un vide entre les clichés, on obtient un contact étroit entre les clichés et les faces du panneau. Les supports de clichés sont constitués d'une part, par un cadre rectangulaire et, d'autre part, par une vitre ou plus généralement un support transparent relativement rigide solidaire du cadre. Le cliché est appliqué sur une face de la vitre et maintenu sur celle-ci par un système à dépression.

La présence de la vitre dans le support de cliché présente certains inconvénients. Tout d'abord, la vitre peut comporter des défauts ou des rayures ou encore des saletés sur sa face, ce qui viendra perturber la définition de la surface à insoler et donc altèrera la précision des pistes conductrices qui seront ainsi réalisées.

En outre, du fait de sa rigidité, la plaque de verre peut présenter des défauts de planéité qui risquent d'entraîner des défauts dans l'application du cliché contre les parois du panneau de circuit imprimé.

De plus, la vitre du support de cliché est relativement rigide et lorsque l'on réalise un vide entre les deux vitres des supports supérieur et inférieur du cliché, cela peut entraîner une rupture de la vitre et donc la mise en indisponibilité de la machine.

Enfin, les deux faces de la vitre peuvent ne pas être rigoureusement parallèles entre elles. Les variations d'épaisseur qui en résultent, même si elles sont minimes, peuvent également altérer la qualité du tracé des pistes conductrices.

Cependant, il faut rappeler que le cliché présente une épaisseur très réduite et il est donc ainsi très flexible et peut donc prendre une flèche importante s'il n'est pas maintenu sur une face plane elle-même relativement rigide constituée, dans les machines connues, par la vitre du support du cliché.

Un objet de la présente invention est de fournir un châssis d'exposition à la lumière pour panneau de circuit imprimé qui permette effectivement d'appliquer de façon très précise les clichés sur les faces du panneau de circuit imprimé tout en évitant les inconvénients liés à la présence d'une vitre ou d'un support transparent analogue dans les supports de clichés du châssis d'exposition.

Pour atteindre ce but selon l'invention, le châssis d'exposition à la lumière des deux faces d'un panneau en vue de réaliser un circuit imprimé double face ou analogue à l'aide d'un premier et d'un deuxième cliché souples disposés de part et d'autre dudit panneau est caractérisé en ce qu'il comprend :
- un premier cadre dépourvu de support plan transparent pour recevoir le premier cliché souple ;
- un deuxième cadre dépourvu de support plan transparent pour recevoir le deuxième cliché souple ;
- des moyens pour positionner et fixer la périphérie desdits premier et deuxième clichés respectivement sur lesdits premier et deuxième cadres ;
- des moyens pour positionner et maintenir ledit panneau entre lesdits premier et deuxième cadres ;
- des moyens pour provoquer le rapprochement desdits cadres munis desdits clichés vers les faces dudit panneau entre une première position écartée et une deuxième position d'exposition ; et
- des moyens pour réaliser une dépression dans l'espace compris entre les cadres munis de leurs clichés et contenant ledit panneau, par quoi lesdits clichés viennent progressivement s'appliquer sur les deux faces dudit panneau.

On comprend que, grâce au fait que le cliché est fixé par toute sa périphérie sur le cadre qui est dépourvu de vitres ou plus généralement de supports plans transparents, il est possible en provoquant le rapprochement des deux cadres d'appliquer progressivement sur les deux faces du panneau les clichés fixés sur les cadres.

De préférence, les moyens pour réaliser la dépression sont activés simultanément avec les moyens de rapprochement. Il est ainsi plus facile en synchronisant le mouvement de rapprochement des cadres et donc des clichés avec la réalisation d'une dépression dans l'espace compris entre les deux cadres munis de leurs clichés d'assurer l'application des clichés relativement souples sur les faces du panneau sans risquer la présence de bulles d'air entre le cliché et les faces du panneau.

Selon un mode préféré de mise en oeuvre, le châssis comprend des moyens pour réaliser un axe de pivotement le long des bords inférieurs des cadres, le rapprochement desdits cadres munis de leurs clichés étant obtenu par pivotement autour dudit axe.

De préférence, encore, les moyens d'aspiration pour créer la dépression sont disposés à proximité des bords supérieurs des cadres et donc des clichés.

D'autres caractéristiques et avantages de l'invention apparaîtront mieux à la lecture de la description qui suit d'un mode préféré de réalisation de l'invention donné à titre d'exemple non limitatif. La description se réfère aux figures annexées, sur lesquelles :
- la figure 1 est une vue de face du châssis d'exposition ;
- la figure 1A est une vue en coupe selon la ligne A-A de la figure 1 ;
- la figure 1B est une vue en coupe selon la ligne B-B de la figure 1 ;
- la figure 1C est une vue en coupe selon la ligne C-C de la figure 1 ;

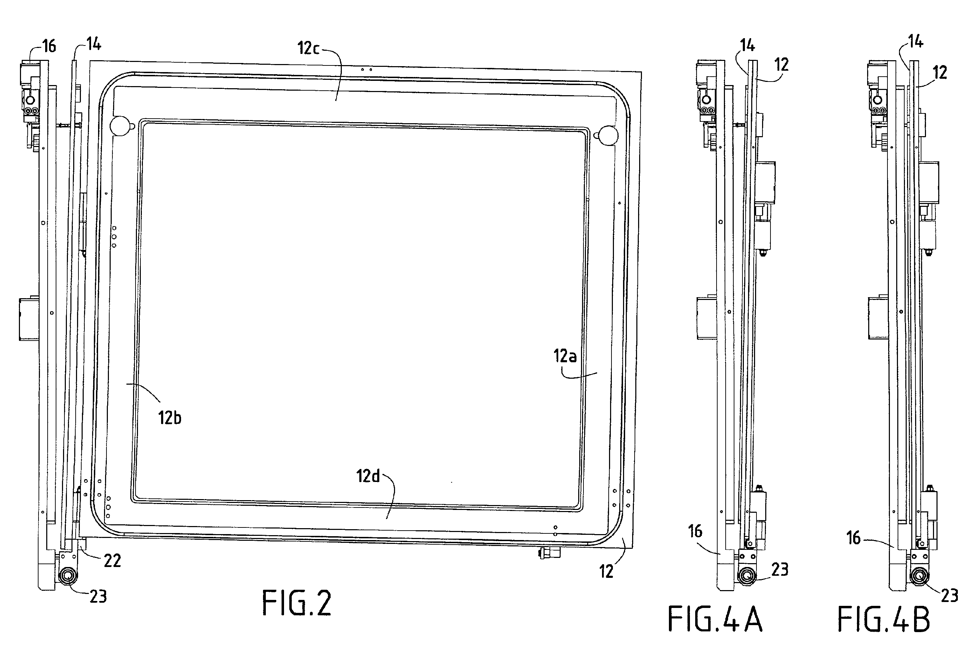

- la figure 2 est une vue de côté du châssis d'exposition, le cadre avant du châssis étant ouvert ;
- la figure 3 est une vue en perspective de l'ensemble du châssis montrant le cadre avant en position ouverte et le cadre intermédiaire écarté du cadre postérieur ;
- les figures 4A et 4B sont des vues de côté du châssis équipé d'un panneau de circuit imprimé respectivement en position écartée et en position fermée ;
- les figures 5A à 5D sont des vues de principe simplifiées montrant la façon dont les deux clichés viennent progressivement se plaquer sur les deux faces du panneau de circuit imprimé ; et
- la figure 6 est une vue de détails de la figure 5A.

Comme le montre mieux la figure 3, dans le mode de réalisation préféré, le châssis d'exposition 10 comporte un cadre avant 12 dépourvu de vitre ou plus généralement de support plan transparent, un cadre intermédiaire 14 et un cadre postérieur 16 également dépourvus de vitre ou support transparent plan. Le cadre avant 12 sert à la fixation du cliché avant, ce cliché étant fixé sur les montants verticaux 12a, 12b et horizontaux 12c, 12d du cadre 12. La fixation initiale des clichés est réalisée par un système de dépression comportant une rainure rectangulaire 18 débouchant dans la face postérieure 20 du cadre 12, c'est-à-dire sur sa face tournée vers le cadre intermédiaire 14. Cette rainure 18, comme on l'expliquera plus en détail ultérieurement, est reliée à un système de dépression.

Le cadre intermédiaire 14 est également constitué par des montants verticaux 14a, 14b et des montants horizontaux 14c et 14d. Le cadre antérieur ou avant 12 est monté sur le cadre intermédiaire par l'intermédiaire d'un axe de pivotement sensiblement vertical 22 disposé le long des montants verticaux 12b du cadre avant et 14a du cadre intermédiaire. Dans sa position d'utilisation, le cadre avant 12 est appliqué contre le cadre intermédiaire 14 et est rendu solidaire du cadre intermédiaire 14 par des moyens de verrouillage non représentés. Le bord inférieur 14d du cadre intermédiaire 14 est relié mécaniquement à un axe de pivotement inférieur 23 s'étendant selon le montant horizontal 14d du cadre intermédiaire 14. La face postérieure du cadre antérieur 12 est, de préférence, munie d'un joint périphérique 17 d'étanchéité apte à coopérer avec le cadre intermédiaire 14. Enfin le cadre postérieur, de préférence fixe 16 qui est de préférence vertical, est constitué également par des montants verticaux 16a, 16b et par des montants horizontaux 16c et 16d.

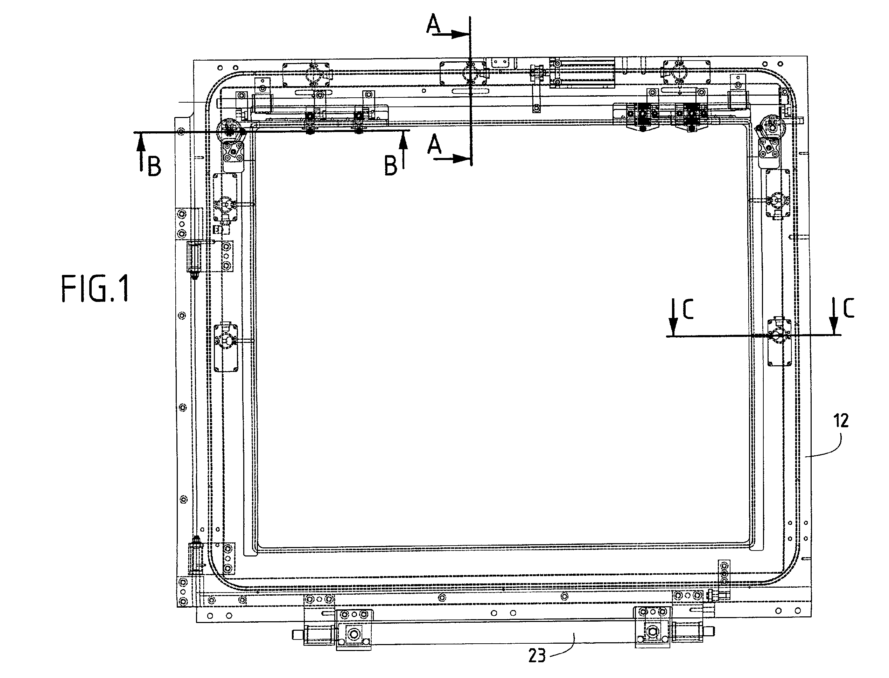

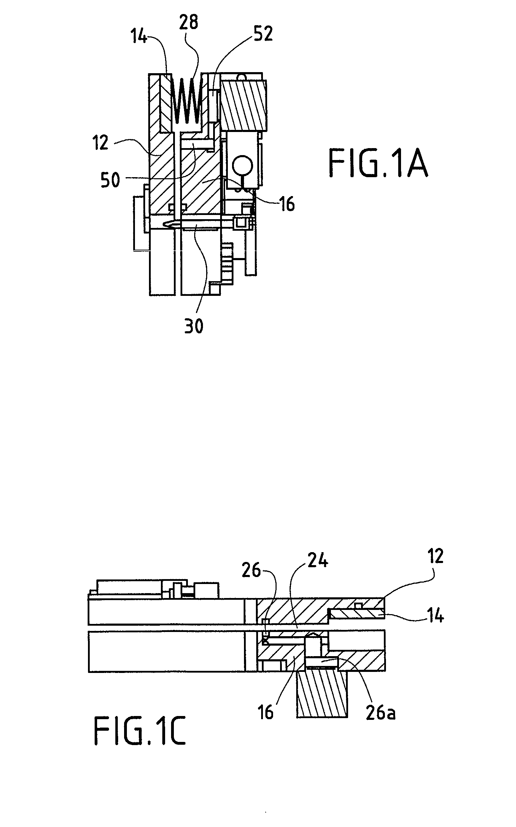

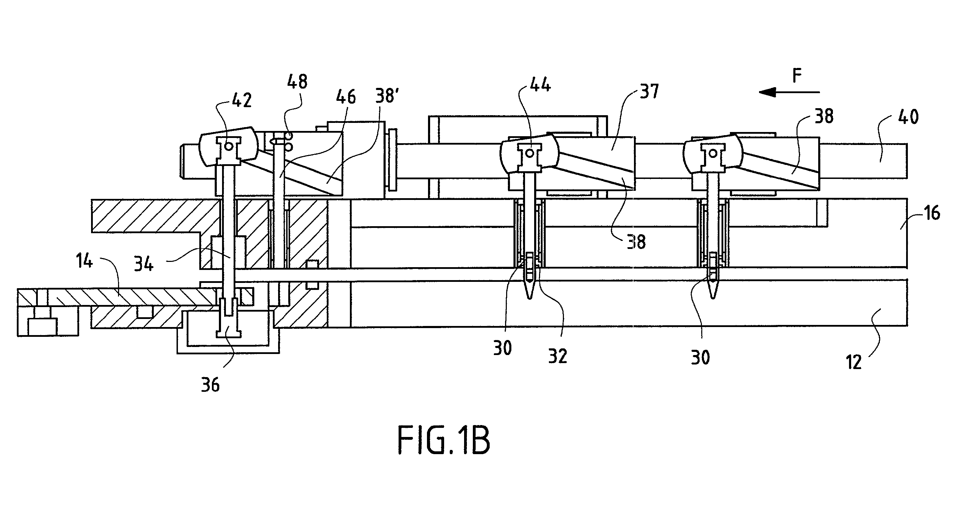

En se référant maintenant plus particulièrement à la figure 1 et aux figures 1A à 1C, on va décrire plus en détail le cadre postérieur 16.

Pour assurer la fixation et le positionnement du cliché arrière, la face avant 24 du cadre postérieur 16 comporte également une rainure 26 reliée par des conduits 26a à une source d'aspiration pour créer un vide. Il faut également préciser qu'est fixé un soufflet d'étanchéité 28 sur toute la périphérie du panneau postérieur 16. Ce soufflet est également fixé sur la périphérie du panneau intermédiaire 14.

En se référant maintenant plus particulièrement à la figure 1B, on va décrire les moyens qui permettent le positionnement des clichés et du panneau par rapport aux cadres du châssis ainsi que les moyens qui permettent de contrôler le rapprochement du cadre antérieur 12 et du panneau par rapport au cadre postérieur 16.

Les moyens de positionnement du panneau de circuit imprimé sont constitués par des pions escamotables 30 montés mobiles dans le montant supérieur du cadre 16. Ces pions peuvent pénétrer dans des orifices de positionnement prévus dans le bord supérieur du panneau. Ces pions 30 présentent un épaulement 32 qui permet de définir la position du panneau selon une direction orthogonale au plan du cadre postérieur 16, la face postérieure du panneau étant en appui sur l'épaulement 32. Le cadre postérieur 16 est équipé également de pions 34 qui permettent de contrôler le rapprochement du cadre intermédiaire 14 et donc du cadre antérieur 12 lorsque ces deux cadres sont solidarisés. Le pion 34 comporte une tête 36 qui est engagée dans le cadre intermédiaire 14. Pour commander le déplacement synchronisé des pions 30 recevant le panneau et des pions 34 de déplacement du cadre intermédiaire, tous les pions coopèrent avec des cames 37 présentant une rainure 38, 38' qui sont déplacées par une tige commune de commande 40 s'étendant parallèlement au bord supérieur du cadre arrière 16. Les pions 30 ou 34 présentent un ergot d'entraînement 42, 44 coopérant avec les rainures 38. Les rainures 38, 38' sont dirigées de telle manière que le déplacement du cadre intermédiaire 14 soit deux fois plus important que le déplacement du panneau. On comprend qu'en déplaçant la tige 40 dans la direction indiquée par la flèche F, on provoque la sortie des pions 30 et 34 hors du cadre inférieur et donc l'écartement du panneau et du cadre intermédiaire par rapport au cadre postérieur 16.

Le positionnement initial des clichés antérieur et postérieur est obtenu à l'aide de pions mobiles tels que 46 qui sont également montés dans le cadre postérieur 16 et plus précisément dans ses montants verticaux. Ces pions 46 sont également escamotables et leur déplacement est commandé par une fourchette 48 elle-même entraînée de préférence par un vérin particulier non représenté sur les figures. Les pions sont escamotés lorsque la fixation des clichés sur les cadres a été réalisée.

Comme le montre mieux la figure 1A, le montant supérieur du cadre postérieur 16 est également équipé de passages d'aspiration 50 qui débouchent dans la face antérieure du montant supérieur de ce cadre et qui sont reliés par des conduites telles que 52 à des pompes à vide constituées de préférence par des systèmes à venturi. Ces passages d'aspiration 50 débouchent nettement au-dessus des pions 30 de supportage du panneau et donc au-dessus du bord supérieur du panneau après que celui-ci ait été mis en place sur les pions 30.

Après avoir décrit les éléments constitutifs principaux du châssis d'exposition, on va en décrire le mode d'utilisation.

L'utilisation du châssis d'exposition 10 décrit précédemment comporte une phase préliminaire de positionnement et de fixation des clichés respectivement sur le cadre antérieur 12 et postérieur 16 puis après cette fixation initiale une phase d'utilisation normale consistant à mettre successivement en place des panneaux de circuit imprimé pour procéder à l'insolation de leurs deux faces à travers les clichés précédemment fixés sur les cadres antérieur et postérieur.

Pour la phase initiale de positionnement et de fixation des clichés, on utilise les pions escamotables 46 du cadre postérieur et les pions 30 de positionnement du panneau.

Le cadre antérieur 12 étant dans sa position ouverte représentée sur la figure 3, on met en place sur les pions 46 le cliché postérieur à l'aide d'orifices calibrés prévus dans le bord supérieur du cliché puis on met en place sur les pions 30 un panneau ayant l'épaisseur des panneaux qui seront insolés ultérieurement ou une cale correspondant à cette épaisseur et on règle également les moyens formant charnière horizontale 23 à l'aide de cales pour adapter le châssis à l'épaisseur des panneaux. Enfin, on dispose sur les ergots 46 le cliché antérieur. Dans cette position, les clichés sont uniquement suspendus par leurs bords supérieurs sur les ergots 46. Puis on fait pivoter le cadre antérieur 12 autour de l'axe vertical 22 et on verrouille le cadre antérieur sur le cadre intermédiaire 14 de telle manière que ces deux cadres ne forment qu'un seul élément. On commande l'aspiration dans les rainures de positionnement 18 et 26 respectivement du cadre antérieur et du cadre postérieur. On obtient ainsi une solidarisation et un positionnement de la périphérie des clichés sur les cadres antérieur et postérieur et donc un alignement précis entre les deux clichés. La précision d'alignement est de l'ordre de 25 microns en tout point des clichés. Après cette opération, on ouvre à nouveau le cadre antérieur 12 pour fixer les clichés avec des moyens complémentaires tels qu'un matériau adhésif respectivement sur le cadre antérieur et sur le cadre postérieur, tout en maintenant l'aspiration dans les rainures. On retire le panneau ou la cale ayant servi au positionnement initial des clichés. Le châssis d'exposition est prêt à être utilisé pour réaliser sur les deux faces de panneau de circuit imprimé les insolations correspondant aux clichés déjà mis en place.

Pour l'utilisation normale du châssis, le cadre avant 12, sur lequel le cliché avant est fixé, étant en position ouverte, on met en place, sur les pions de supportage 30 qui sont en position sortie, un panneau à insoler puis on referme le cadre antérieur 12 sur le cadre intermédiaire 14 et on le verrouille sur celui-ci.

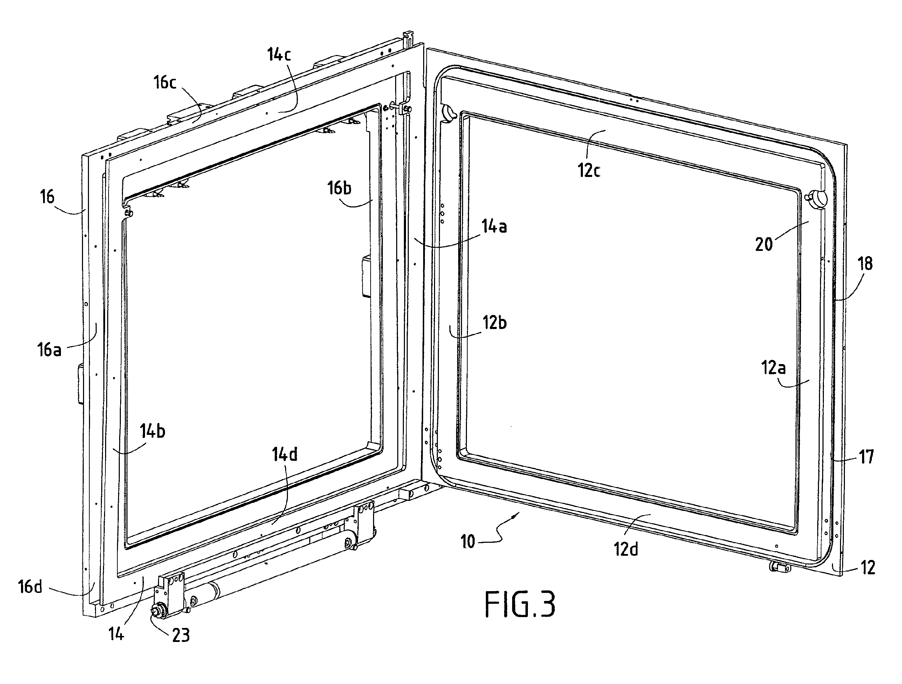

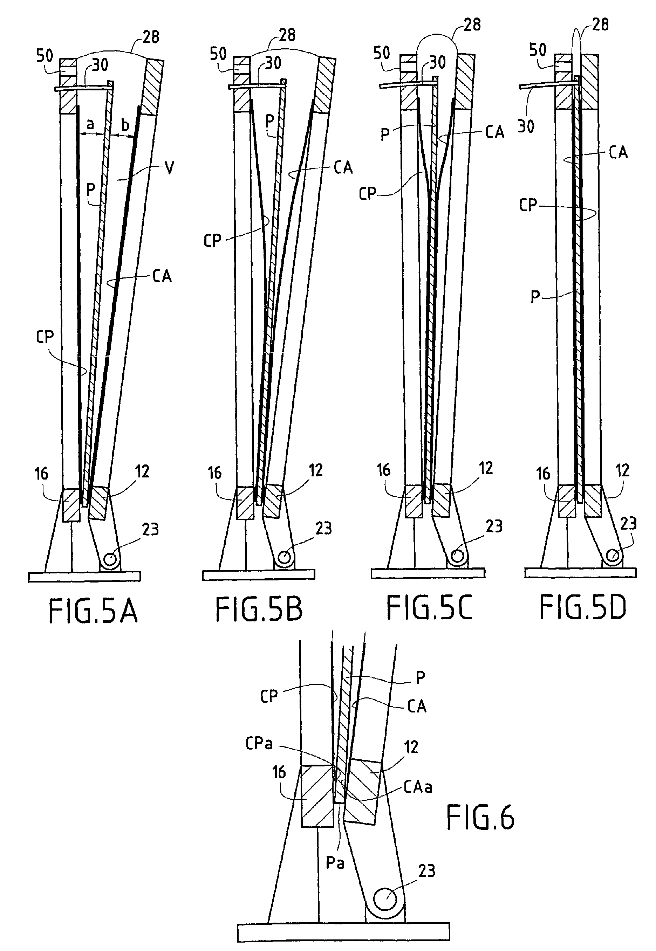

En se référant aux figures 5A à 5D et 6, on va décrire la façon dont on obtient l'application des clichés antérieur et postérieur sur les faces du panneau de circuit imprimé au fur et à mesure du rapprochement de l'ensemble constitué par le cadre antérieur 12 et le cadre intermédiaire 14 par rapport au cadre postérieur 16.

Ces figures sont simplifiées, c'est-à-dire qu'on a représenté seulement le cadre antérieur 12 et non le cadre intermédiaire 14. En effet, lors des opérations de rapprochement, le cadre 14 est verrouillé sur le cadre antérieur 12, ces deux cadres formant un ensemble.

Avant cette description détaillée, on peut indiquer que, conformément à l'invention, le rapprochement contrôlé des clichés de part et d'autre du panneau est réalisé en synchronisme avec l'aspiration à l'aide des orifices 50 ménagés dans le montant supérieur du cadre postérieur et relié aux pompes à vide. On comprend en effet que le volume limité par le cadre antérieur sur lequel est fixé le cliché antérieur et par le cadre postérieur 16 sur lequel est fixé le cliché postérieur est rendu étanche, d'une part, par les lèvres d'étanchéité disposées entre le panneau antérieur et le panneau intermédiaire et, d'autre part, par le soufflet d'étanchéité périphérique monté entre le cadre intermédiaire et le cadre postérieur.

La figure 5A montre la position initiale du châssis. Le panneau P est suspendu par les pions 30 et les clichés avant CA et postérieur CP sont respectivement fixés sur les cadres avant 12 et postérieur 16 et le cadre intermédiaire 14 est verrouillé sur le cadre avant 12. Le soufflet 28 assure l'étanchéité du volume V limité par les cadres antérieur et postérieur. L'épaulement des pions 30 maintient la partie supérieure du panneau P de telle manière que les angles a et b soient sensiblement égaux. Les angles a et b sont très exagérés pour rendre la figure 5A plus lisible. Ces angles sont en réalité de l'ordre de 5 à 7°. La figure 6 montre que le bord inférieur Pa est en contact avec le bord inférieur CAa et CPa respectivement des clichés avant et postérieur, les bords des clichés étant fixés sur les cadres. Cette situation est rendue possible grâce à l'utilisation de cales amovibles de réglage au droit de la charnière 23 adaptées à l'épaisseur du panneau. Il faut bien sûr également prévoir des cales amovibles également adaptées à l'épaisseur du panneau au droit des têtes des pions 34 de rapprochement du cadre intermédiaire 14, pour avoir une course constante des moyens de rapprochement et qu'en position finale les cadres soient parallèles entre eux.

Dans l'étape suivante représentée sur la figure 5B, on commence à créer une dépression dans le volume V par les orifices 50 du cadre postérieur 16. Sous l'effet de la dépression, les clichés qui sont souples et seulement fixés par leur périphérie prennent une courbure dont la flèche a été beaucoup exagérée sur la figure pour rendre celle-ci plus lisible. En revanche, le panneau P reste plan puisque la même dépression règne des deux côtés du panneau. Lorsque l'on commence à rapprocher le panneau P et le cliché antérieur CA du cliché postérieur, les parties inférieures des clichés viennent se plaquer régulièrement et progressivement sur la partie inférieure des deux faces du panneau, le rapprochement maintenant sensiblement l'égalité des angles a et b. Du fait que, de plus, l'aspiration dans le volume V est réalisée en partie supérieure du volume V, les clichés se plaquent progressivement sur les deux faces du panneau en commençant par leur partie inférieure sans que des bulles d'air puissent être emprisonnées.

La figure 5C montre une position intermédiaire dans laquelle la plus grande partie des clichés a déjà été plaquée contre les faces du panneau P.

La figure 5D montre la position finale dans laquelle les clichés CA et CP sont intégralement appliqués contre les faces du panneau P. On peut alors procéder à l'insolation du panneau P à travers les clichés CA et CP. Durant l'insolation, la dépression entre les clichés et le panneau est maintenue.

En relation avec les figures 5A à 5D on a décrit la façon dont les clichés étaient appliqués progressivement contre les deux faces du panneau selon la direction verticale. On comprend que, pour ce qui concerne la direction horizontale les clichés présentent bien sûr également une courbure. Lors du rapprochement du cadre antérieur 12 du panneau P vers le cadre postérieur 16, la partie centrale des clichés entre d'abord en contact avec les faces du panneau puis progressivement toute la largeur des clichés. On évite ainsi d'emprisonner des bulles d'air entre le panneau et les clichés.

Dans la description précédente, on a envisagé le cas où le cadre antérieur et le panneau étaient rapprochés du cadre postérieur par pivotement autour d'un axe disposé le long du bord inférieur du cadre antérieur. Il va de soi que le mouvement de rapprochement pourrait se faire différemment.

Le cadre antérieur et le panneau pourraient être rapprochés du cadre postérieur par un mouvement de translation orthogonal au plan du cadre postérieur. On peut également rapprocher les deux cadres du panneau celui-ci restant immobile. Il est nécessaire que le châssis comporte des moyens pour maintenir le panneau vertical à travers les moyens d'étanchéité disposés selon la périphérie des couches antérieure et postérieure.

Dans ce cas l'axe de pivotement inférieur 23 est bien sûr supprimé. Des pions de rapprochement analogues aux pions 34 sont prévus dans le montant inférieur du cadre postérieur 16, ces pions coopérant avec le montant inférieur du cadre intermédiaire. Les pions inférieurs de rapprochement peuvent être commandés, quant à leur déplacement, par des cames identiques ou analogues aux cames 37 du montant supérieur. La tige 40 des cames supérieures peut être motrice, la tige de commande des cames inférieures étant reliée à la tige supérieure 40 par une courroie de transmission. Si le rapport de transmission est égal à 1 les cadres antérieur 12 et postérieur 16 restent parallèles durant tout le déplacement.

Si les cames inférieures sont commandées par des moyens indépendants, par exemple un vérin, le rapprochement des deux cadres sera la composition d'un mouvement relatif de translation et d'un mouvement relatif de pivotement.

Sous l'effet de la dépression créée entre les deux cadres, les deux clichés prendront une courbure identique à celle qu'on a déjà décrite. Lors du rapprochement des clichés par rapport au panneau, rapprochement durant lequel le panneau est maintenu à égale distance des deux cadres, c'est la zone centrale des clichés qui viendra en premier au contact des faces du panneau. Puis, progressivement et simultanément ce contact se produira vers les bords horizontaux et verticaux du panneau. Par ce processus, on évite également d'emprisonner des bulles d'air entre le panneau et les clichés.

De préférence, le premier cadre est vertical et le deuxième cadre, dans sa première position, présente une angulation réduite par rapport au premier cadre.

## Revendications

1. Châssis d'exposition à la lumière des deux faces d'un panneau en vue de réaliser un circuit imprimé double face ou analogue à l'aide d'un premier et d'un deuxième cliché souple disposés de part et d'autre dudit panneau, **caractérisé en ce qu'**il comprend :
- un premier cadre, dépourvu de support plan transparent, pour recevoir le premier cliché souple ;
- un deuxième cadre, dépourvu de support plan transparent, pour recevoir le deuxième cliché souple ;
- des moyens pour positionner et fixer la périphérie desdits premier et deuxième clichés respectivement sur lesdits premier et deuxième cadres ;
- des moyens pour positionner et maintenir ledit panneau entre lesdits premier et deuxième cadres ;
- des moyens pour provoquer le rapprochement desdits cadres munis desdits clichés vers les faces dudit panneau entre une première position écartée et une deuxième position d'exposition ; et
- des moyens pour réaliser une dépression dans l'espace compris entre les cadres munis de leurs clichés et contenant ledit panneau, par quoi lesdits clichés viennent progressivement s'appliquer sur les deux faces dudit panneau.

2. Châssis d'exposition selon la revendication 1, **caractérisé en ce que** les moyens pour réaliser la dépression sont activés simultanément avec les moyens de rapprochement.

3. Châssis d'exposition selon la revendication 2, **caractérisé en ce que** ledit premier cadre est vertical et ledit deuxième cadre, dans sa première position, présente une angulation réduite par rapport au premier cadre.

4. Châssis d'exposition selon la revendication 3, **caractérisé en ce que** lesdits cadres comportent chacun un bord inférieur et **en ce que** ledit châssis comprend en outre des moyens pour réaliser un axe de pivotement le long desdits bords inférieurs, le rapprochement desdits cadres étant obtenu par le pivotement autour dudit axe.

5. Châssis d'exposition selon l'une quelconque des revendications 2 à 4, **caractérisé en ce que** les moyens de positionnement et de maintien dudit panneau comprennent des moyens de supportage dudit panneau par son bord supérieur.

6. Châssis d'exposition selon la revendication 5, **caractérisé en ce que** les moyens de supportage dudit panneau comprennent des pions faisant saillie dans la face interne du bord supérieur du premier cadre et des trous ménagés dans ledit panneau à proximité de son bord supérieur et aptes à coopérer avec lesdits pions.

7. Châssis d'exposition selon l'une quelconque des revendications 2 à 6, **caractérisé en ce qu'**il comprend des moyens pour réaliser une étanchéité entre les périphéries desdits cadres et **en ce que** lesdits moyens pour créer une dépression comprennent des moyens d'aspiration du gaz contenu dans le volume limité par lesdits cadres munis de leurs clichés et lesdits moyens d'étanchéité.

8. Châssis d'exposition selon la revendication 7, **caractérisé en ce que** lesdits moyens d'aspiration sont disposés à proximité des bords supérieurs desdits cadres.

9. Châssis d'exposition selon l'une quelconque des revendications 2 à 8, **caractérisé en ce qu'**il comprend en outre des moyens de synchronisation des moyens pour créer une dépression et des moyens de rapprochement desdits cadres, de telle manière que les deux clichés soient appliqués progressivement sur les deux faces dudit panneau depuis le bord inférieur desdits clichés jusqu'à leur bord supérieur.

10. Châssis d'exposition selon l'une quelconque des revendications 2 à 9, **caractérisé en ce que** lesdits moyens de positionnement des clichés par rapport auxdits cadres comprennent des pions de positionnement faisant saillie hors de la face interne du bord supérieur du premier cadre et des trous ménagés dans lesdits clichés à proximité de leur bord supérieur et aptes à coopérer avec lesdits pions de positionnement.

11. Châssis d'exposition selon l'une quelconque des revendications 1 à 10, **caractérisé en ce que** les moyens de déplacement comprennent des moyens pour rapprocher le panneau dudit premier cadre et des moyens pour rapprocher le deuxième cadre du premier cadre de telle manière que la distance entre le premier cadre et le panneau reste sensiblement égale à la distance entre le panneau et le deuxième cadre.

12. Châssis d'exposition selon l'une quelconque des revendications 1 à 11, **caractérisé en ce que** les moyens pour maintenir un cliché sur un cadre comprennent une rainure périphérique ménagée dans la face dudit cadre destinée à recevoir le cliché et des moyens pour relier ladite rainure à des moyens d'aspiration.
